(19) **Europäisches Patentamt**

**European Patent Office**

**Office européen des brevets**

(11) **EP 1 653 624 A2**

(12) **EUROPÄISCHE PATENTANMELDUNG**

(43) Veröffentlichungstag:
03.05.2006 Patentblatt 2006/18

(51) Int Cl.:
*H03M 1/10* (2006.01)

(21) Anmeldenummer: 05023300.6

(22) Anmeldetag: 25.10.2005

(84) Benannte Vertragsstaaten:
AT BE BG CH CY CZ DE DK EE ES FI FR GB GR
HU IE IS IT LI LT LU LV MC NL PL PT RO SE SI
SK TR
Benannte Erstreckungsstaaten:
AL BA HR MK YU

(30) Priorität: 29.10.2004 DE 102004052575

(71) Anmelder: Steffek, Martin
82288 Kottgeisering (DE)

(72) Erfinder: Steffek, Martin
82288 Kottgeisering (DE)

(74) Vertreter: Lermer, Christoph
Patent- & Rechtsanwälte
Grosse Bockhorni Schumacher
Forstenrieder Allee 59
81476 München (DE)

(54) **Schaltung und Verfahren zur Integration einer Ladung**

(57)    Die vorliegende Erfindung betrifft eine Schaltung zur Integration einer Ladung, aufweisend einen Eingang 8 zum Empfangen einer Ladung, einen Integrierer 7 zum Integrieren eines Eingangssignals und zum Ausgeben eines integralen Wertes sowie einen Analog-Digital-Umsetzer 4 zum Umsetzen eines analogen Eingangssignals in ein entsprechendes digitales Ausgangssignal.

Bei derartigen Schaltungen besteht der Nachteil, dass die Integration der von der Ladungsquelle 2 erzeugten Ladung üblicherweise unter Verwendung eines analogen Integrierers erfolgt. Hierfür bekannte Integrierer weisen hohe Leckströme auf, welche in den von dem Integrierer bestimmten integralen Wert einfließen und diesen verändern. Die Korrektur dieser Leckströme ist sehr aufwendig.

Gemäß der vorliegenden Erfindung wird vorgeschlagen, dass der Analog-Digital-Umsetzer 4 zunächst ein der von dem Eingang 8 empfangenen Ladung entsprechendes digitales Ausgangssignal erzeugt und der Integrierer 7 als digitaler Integrierer ausgebildet ist, der anschließend das von dem Analog-Digital-Umsetzer 4 empfangene digitale Ausgangssignal zum Ausgeben eines integralen Wertes integriert.

Weiter betrifft die vorliegende Erfindung ein entsprechendes Verfahren zur Integration einer Ladung.

**Fig. 1**

EP 1 653 624 A2

**Beschreibung**

Die vorliegende Erfindung betrifft eine Schaltung und ein Verfahren zur Integration einer Ladung mit den Merkmalen des Oberbegriffs des unabhängigen Anspruchs 1 bzw. 7.

Derartige Schaltungen werden im Stand der Technik häufig in Verbindung mit Messschaltungen verwendet, bei denen eine Ladungsquelle eine Ladung erzeugt.

Eine vorbekannte Schaltung zur Integration einer Ladung ist in Figur 4 gezeigt und wird im Folgenden beschrieben.

Eine Ladungsquelle 41 ist über einen Eingang 48 mit einem analogen Integrierer 42 verbunden. Bei der Ladungsquelle 41 handelt es sich naturgemäß um ein analoges Bauteil.

Die Ladungsquelle 41 erzeugt in Folge einer Krafteinwirkung eine Ladung. Diese Ladung wird von dem analogen Integrierer 42 zur Erzeugung eines analogen integralen Wertes integriert.

Da das Integral über eine Ladung eine Spannung ist, steht am Ausgang des analogen Integrierers 42 ein analoger integraler Wert in Form einer Spannung zur Verfügung. Der analoge Integrierer 42 verstärkt somit die empfangene Ladung und setzt die empfangene Ladung in eine Spannung um.

Dieser analoge integrale Wert wird von einem mit dem analogen Integrierer 42 verbundenen Analog-Digital-Umsetzer 43 in einen digitalen Ausgangswert umgesetzt und über einen Ausgang 49 ausgegeben. Die Verwendung eines digitalen Ausgangswertes hat den Vorteil, dass digitale Werte leicht von in Messschaltung üblicherweise verwendeten Mikroprozessoren weiterverarbeitet werden können.

Die vorstehend beschriebene vorbekannte Schaltung zur Integration einer von einer Ladungsquelle erzeugten Ladung weist einen erheblichen systembedingten Nachteile auf.

Analoge Integrierer weisen Leckströme auf. Die Leckströme wirken wie ein (üblicherweise sehr kleines) Eingangssignal des Integrierers, das selbst dann auftritt, wenn die von der Ladungsquelle ausgegebene Ladung gleich Null ist. Die Leckströme führen dazu, dass der von dem analogen Integrierer ausgegebene integrale Wert einen über die Messzeit immer größer werdenden Anteil an aufintegrierten Leckströmen enthält und sich somit zunehmend von dem wahren integralen Wert des Integrals über die von der Ladungsquelle tatsächlich ausgegebene Ladung entfernt.

Daher wird in der Spezifikation von analogen Integrierern üblicherweise angegeben, nach welcher Zeit das Integral über die Leckströme einen gewissen Wert erreicht.

Die analoge Korrektur dieser Leckströme ist sehr aufwendig und nur ansatzweise möglich, da die Leckströme stark von der Arbeitstemperatur des analogen Integrators abhängen.

Verwendung finden derartige Schaltungen zur Integration einer Ladung in vielen Bereichen der Messtechnik, in denen ladungserzeugende Aufnehmer verwendet werden. Ein typisches Beispiel einer Einsatzmöglichkeit einer derartigen Schaltung ist ein in der Automobiltechnik eingesetztes Messrad, welches anstelle eines normalen Rades an einem Fahrzeug montiert wird und während der Fahrt die auf das Messrad einwirkenden Kräfte misst.

Ausgehend von dem vorstehend beschriebenen Stand der Technik ist es Aufgabe der vorliegenden Erfindung, eine Schaltung und ein Verfahren zur Integration einer Ladung bereitzustellen, welche die Integration einer Ladung auf besonders einfache Weise mit hoher Genauigkeit ermöglichen. Weiter soll die Schaltung bei für die erzielte Genauigkeit vergleichsweise geringen Kosten einen möglichst robusten und einfachen Aufbau aufweisen.

Die vorstehende Aufgabe wird bei einer Schaltung zur Integration einer Ladung mit den Merkmalen des Oberbegriffes des unabhängigen Anspruches 1 durch die Merkmale des kennzeichnenden Teiles des unabhängigen Anspruches 1 gelöst.

Weiter wird die vorstehende Aufgabe bei einem Verfahren mit den Merkmalen des Oberbegriffes des unabhängigen Anspruches 7 durch die Merkmale des kennzeichnenden Teiles des unabhängigen Anspruches 7 gelöst.

Vorteilhafte Ausgestaltungen der vorliegenden Erfindung finden sich in den Unteransprüchen.

Gemäß der vorliegenden Erfindung weist eine Schaltung zur Integration einer Ladung einen Eingang zum Empfangen einer Ladung, einen Integrierer zum Integrieren eines Eingangssignals und zum Ausgeben eines integralen Wertes sowie einen Analog-Digital-Umsetzer zum Umsetzen eines analogen Eingangssignals in ein entsprechendes digitales Ausgangssignal auf. Dabei erzeugt der Analog-Digital-Umsetzer ein der von dem Eingang empfangenen Ladung entsprechendes digitales Ausgangssignal und ist der Integrierer als digitaler Integrierer ausgebildet, welcher das von dem Analog-Digital-Umsetzer empfangene digitale Ausgangssignal zum Ausgeben eines integralen Wertes integriert.

Erfindungsgemäß ist somit der Analog-Digial-Umsetzer vor dem Integrierer vorgesehen. Im Stand der Technik sind selbst-abgleichende Analog-Digital-Umsetzer bekannt, so dass Störeinflüsse in Folge des Analog-Digital-Umsetzers äußerst gering gehalten werden können.

Weiter ist erfindungsgemäß der Integrierer als digitaler Integrierer ausgebildet. Bei digitalen Integrierern ist es vorteilhaft, dass keine Leckströme mit integriert werden, da digitale Integrierer mathematisch exakt arbeiten. Deshalb bleibt der von dem digitalen Integrierer ausgegebene digitale integrale Wert über die Zeit konstant, wenn das Eingangssignal gleich Null ist.

Die Verwendung eines digitalen Integrierers führt dazu, dass am Ausgang der erfindungsgemäßen Schaltung ein digitaler integraler Wert (digitales Ausgangssignal) bereitgestellt wird. Dies erlaubt den flexiblen Einsatz der erfindungsgemäßen Schaltung zur Integration einer Ladung in bestehenden digitalen Messsystemen, ohne dass eine grundsätzliche Modifikation des Aufbaus des jeweiligen Messsystems erforderlich ist.

Soll die erfindungsgemäße Schaltung jedoch in einem analogen Messsystem verwendet werden, so kann an einem Ausgang der erfindungsgemäßen Schaltung ein (vorzugsweise selbstabgleichender) Digital-Analog-Umsetzer vorgesehen sein.

Zusammenfassend kann mit der erfindungsgemäßen Schaltung zur Integration einer Ladung durch Ersetzen des vorbekannten analogen Integrierers durch einen digitalen Integrierer mit vorgeschaltetem Analog-Digital-Umsetzer auf besonders einfache Weise eine erhebliche Verbesserung der Genauigkeit des von der Schaltung ermittelten integralen Wertes erzielt werden. Auf die im Stand der Technik üblicherweise verwendeten komplizierten Schaltungen zur Korrektur von Leckströmen des analogen Integrierers kann verzichtet werden. In der Folge weist die erfindungsgemäße Schaltung einen besonders einfachen, robusten und kostengünstigen Aufbau auf.

Gemäß einer bevorzugten Ausführungsform der vorliegenden Erfindung weist die Schaltung ferner einen Strom-Spannungs-Umsetzer zur Erzeugung einer von einem Eingangsstrom abhängenden Ausgangsspannung auf, wobei der Strom-Spannungs-Umsetzer ausgebildet ist, einen in Folge einer von dem Eingang empfangenen Ladung fließenden Strom in eine Spannung umzusetzen und diese Spannung an den Analog-Digital-Umsetzer auszugeben. Dabei erzeugt der Analog-Digital-Umsetzer ein der von dem Strom-Spannungs-Umsetzer empfangenen Spannung entsprechendes digitales Ausgangssignal und gibt es an den digitalen Integrierer aus.

Ein Umsetzen eines in Folge einer empfangenen Ladung fließenden Stromes in eine Spannung ist mittels bekannter selbstabgleichender Strom-Spannungs-Umsetzer mit hoher Genauigkeit möglich. Die von dem Strom-Spannungs-Umsetzer ausgegebene Spannung kann noch einfacher als die empfangene Ladung mittels eines konventionellen selbstabgleichenden Analog-Digital-Umsetzers digitalisiert und an den digitalen Integrierer zur Integration ausgegeben werden.

Vorzugsweise weist die Messschaltung ferner eine Korrekturschaltung auf, die zwischen dem Analog-Digital-Umsetzer und dem digitalen Integrierer angeordnet ist. Dabei ist die Korrekturschaltung ausgebildet, um einen in dem von dem Analog-Digital-Umsetzer empfangenen digitalen Ausgangssignal enthaltenen Gleichanteil zu detektieren und vor der Ausgabe des digitalen Ausgangssignals an den digitalen Integrierer zu korrigieren.

Eine derartige Korrekturschaltung ist sinnvoll, da selbst bei Verwendung von selbstabgleichenden Analog-Digital-Umsetzern über längere Laufzeiten Restfehler unterhalb der Digitalisierungsstufe auftreten.

Solche Restfehler unterhalb der Digitalisierungsstufe sind eine bei den in der Praxis zur Verfügung stehenden nicht-idealen Analog-Digital-Umsetzern auftretende statistische Größen. Dies bedeutet, dass die Restfehler unterhalb der Digitalisierungsstufe über eine gewisse Laufzeit des Analog-Digital-Umsetzers mit einer gewissen Wahrscheinlichkeit mit einer gewissen Häufigkeit auftreten. Über lange Laufzeiten bilden die Restfehler unterhalb der Digitalisierungsstufe somit einen Gleichanteil in dem von dem Analog-Digital-Umsetzer ausgegebenen digitalen Signal.

Dieser Gleichanteil verfälscht ein mittels des Aufnehmers zu bestimmendes Messergebnis.

Daher ist es in diesem Fall besonders vorteilhaft, wenn die Korrekturschaltung das von dem Analog-Digital-Umsetzer empfangene digitale Ausgangssignal über einen einstellbaren Zeitraum mittelt, um einen in dem digitalen Ausgangssignal enthaltenen Gleichanteil zu detektieren.

Auf diese Weise ist das Detektieren eines Gleichanteils in dem das von dem Analog-Digital-Umsetzer empfangenen digitalen Ausgangssignal besonders einfach möglich.

Weiter ist es in diesem Fall besonders vorteilhaft, wenn die Korrekturschaltung einen ermittelten Gleichanteil in dem von dem Analog-Digital-Umsetzer empfangenen digitalen Ausgangssignal vor der Ausgabe an den digitalen Integrierer subtrahiert.

Eine derartige Differenzbildung ist schaltungstechnisch besonders einfach zu bewerkstelligen. Natürlich ist mit geeigneten Mitteln sicherzustellen, dass nur ein auf Restfehler unterhalb der Digitalisierungsstufe zurückzuführender Gleichanteil und kein auf eine erzeugte Ladung zurückzuführendes Signal subtrahiert wird. Da der auf Restfehler unterhalb der Digitalisierungsstufe zurückzuführende Gleichanteil üblicherweise wesentlich kleiner als ein in Folge einer empfangenen Ladung auftretendes Signal ist, kann dies schaltungstechnisch einfach bewerkstelligt werden.

Da die erfindungsgemäße Schaltung eine Integration von Ladung mit hoher Genauigkeit und hoher Langzeitstabilität erlaubt, eignet sie sich besonders gut für den Fall, in dem der Eingang mit einer Ladungsquelle in Form eines Piezo-Elements verbunden ist.

Derartige Piezo-Elemente werden häufig zur Messung von Druck- oder Scherkräften eingesetzt und erzeugen in Folge einer Krafteinwirkung eine Ladung, die von der einwirkenden Kraft abhängt. Aufgrund ihrer hohen Robustheit sind Piezo-Elemente insbesondere auch für den Einsatz im Maschinenbau und insbesondere im Fahrzeugbau geeignet. Auch der Einsatz in Messrädern ist möglich.

Obwohl Piezo-Elemente analoge Bauelemente sind, geben sie eine echte Null als Signal aus, wenn sich die auf das Piezo-Element einwirkende Kraft nicht ändert. Auch weisen die von Piezo-Elementen üblicherweise zu messenden dynamischen Kräfte keinen Gleichanteil auf, so dass ein auf Restfehler unterhalb der Digitalisierungsstufe zurückzuführender Gleichanteil besonders sicher von einem auf eine erzeugte Ladung zurückzuführenden Signal unterschieden werden kann.

Die vorstehend genannte Aufgabe wird gemäß der vorliegenden Erfindung auch von einem Verfahren zur Integration einer Ladung gelöst, das die folgenden Schritte aufweist:

- Integrieren eines Eingangssignals und Ausgeben eines integralen Wertes; sowie
- Umsetzen eines analogen Eingangssignals in ein entsprechendes digitales Ausgangssignal,

wobei in dem Schritt des Umsetzen eines analogen Eingangssignals in ein entsprechendes digitales Ausgangssignal ein digitales Ausgangssignal erzeugt wird, welches einer empfangenen Ladung entspricht, und wobei der Schritt des Integrieren erst nach dem Schritt des Umsetzen eines analogen Eingangssignals in ein entsprechendes digitales Ausgangssignal unter Verwendung des digitalen Ausgangssignals digital erfolgt.

Da erfindungsgemäß zunächst ein Umsetzen eines einer empfangenen Ladung entsprechenden analogen Eingangssignals in ein digitales Ausgangssignal erfolgt und dieses digitale Ausgangssignal erst anschließend digital integriert wird, kann die Integration mathematisch korrekt und daher mit besonders hoher Genauigkeit durchgeführt werden.

Gemäß einer bevorzugten Ausführungsform weist das Verfahren ferner den Schritt des Umsetzen eines in Folge einer empfangenen Ladung fließenden Stroms in eine Spannung auf, wobei der Schritt des Umsetzen eines analogen Eingangssignals in ein entsprechendes digitales Ausgangssignal unter Verwendung des zuvor in eine Spannung umgesetzten Stroms erfolgt.

Vorzugsweise weist das Verfahren vor dem Schritt des Integrieren ferner die Schritte des Detektieren eines in dem digitalen Ausgangssignal enthaltenen Gleichanteils und der Korrektur des digitalen Ausgangssignals auf.

Dabei ist es vorteilhaft, wenn der Schritt des Detektieren eines in dem digitalen Ausgangssignal enthaltenen Gleichanteils durch Mitteln des digitale Ausgangssignals über einen einstellbaren Zeitraum erfolgt.

Bevorzugt erfolgt der Schritt der Korrektur des digitalen Ausgangssignals durch Subtraktion des ermittelten Gleichanteils von dem digitalen Ausgangssignal.

Im Folgenden wird die vorliegende Erfindung unter Bezugnahme auf die beigefügten Figuren näher beschrieben. In diesen Figuren sind gleiche Elemente mit gleichen Bezugszeichen versehen. Dabei zeigt

Figur 1   ein Blockdiagramm einer besonders bevorzugten Ausführungsform der erfindungsgemäßen Schaltung zur Integration einer Ladung;

Figur 2   ein Blockdiagramm einer alternativen Ausführungsform der erfindungsgemäßen Schaltung zur Integration einer Ladung;

Figur 3   ein Flussdiagramm einer besonders bevorzugten Ausführungsform des erfindungsgemäßen Verfahrens zur Integration einer Ladung; und

Figur 4   eine Schaltung zur Integration einer Ladung nach dem Stand der Technik.

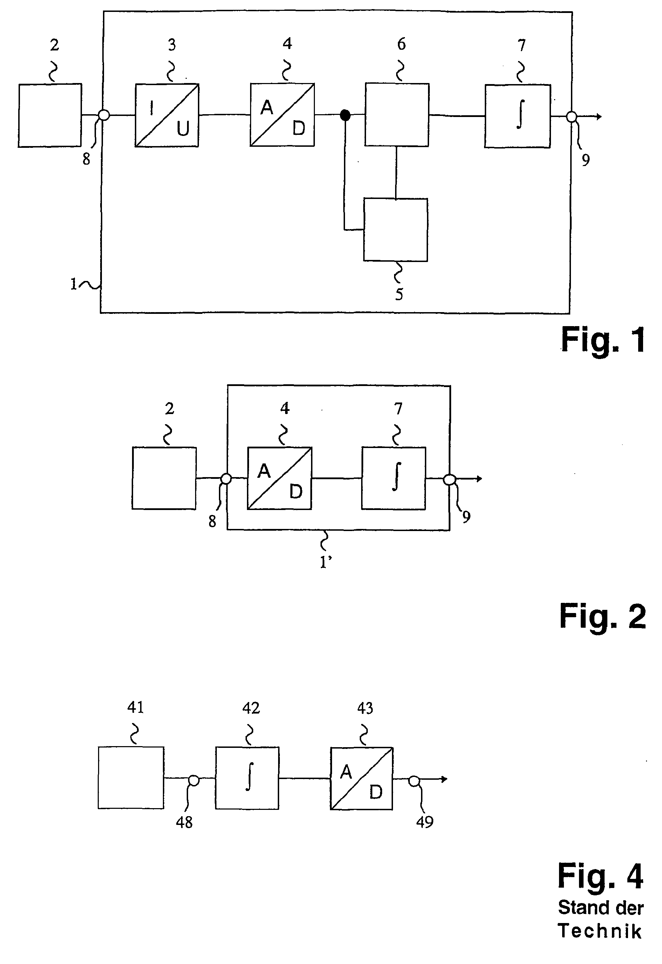

Im Folgenden wird unter Bezugnahme auf Figur 1 eine besonders bevorzugte Ausführungsform der erfindungsgemäßen Schaltung zur Integration einer Ladung beschrieben.

Die in Figur 1 gezeigte erfindungsgemäße Schaltung 1 zur Integration einer Ladung ist über einen Eingang 8 mit einer Ladungsquelle 2 in Form eines als Druckaufnehmer ausgebildeten Piezo-Elements verbunden. Somit muss die Ladungsquelle 2 selber nicht Teil der erfindungsgemäßen Schaltung sein.

Infolge einer auf den Aufnehmer wirkenden Kraft findet in der als Piezo-Element ausgebildeten Ladungsquelle 2 eine Freisetzung von Ladungsträgern statt, in deren Folge bei entsprechendem Abgriff ein Stromfluss detektiert werden kann. Vorzugsweise ist dabei die von der Ladungsquelle 2 freigesetzte Menge an Ladungsträgern proportional zu einer Änderung der auf die Ladungsquelle 2 wirkenden Kraft.

Anstelle eines Piezo-Elements kann jedoch auch ein anderes Ladungen erzeugendes Bauelement als Ladungsquelle verwendet werden.

Die Ladungsquelle 2 ist über den Eingang 8 der in Figur 1 gezeigten erfindungsgemäßen Schaltung 1 zur Integration einer Ladung mit einem selbstabgleichenden Strom-Spannungs-Umsetzer 3 verbunden. Der Strom-Spannungs-Umsetzer 3 ist ein konventionelles elektrisches Bauelement, welches eine von einem Eingangsstrom abhängende Ausgangsspannung erzeugt.

Da in Figur 1 der Strom-Spannungs-Umsetzer 3 über den Eingang 8 mit der Ladungsquelle 2 verbunden ist, setzt der Strom-Spannungs-Umsetzer 3 einen elektrischen Strom, der in Folge einer Freisetzung von Ladungsträgern von der Ladungsquelle 2 bewirkt wird, in eine Ausgangsspannung um. Vorzugsweise ist die von dem Strom-Spannungs-Umsetzer 3 ausgegebene Ausgangsspannung dabei direkt proportional zum Eingangsstrom.

Diese Ausgangsspannung wird von dem Strom-Spannungs-Umsetzer 3 an einen mit dem Strom-Spannungs-Umsetzer 3 verbundenen selbstabgleichenden Analog-Digital-Umsetzer 4 ausgegeben.

Der Analog-Digital-Umsetzer 4 digitalisiert die von dem Strom-Spannungs-Umsetzer 3 empfangene Spannung und erzeugt somit ein der empfangenen Spannung entsprechendes digitales Ausgangssignal.

Da die von dem Strom-Spannungs-Umsetzer 3 erzeugte Spannung der von der Ladungsquelle 2 erzeugten Ladung entspricht, hängt auch das von dem Analog-Digital-Umsetzer 4 ausgegebene digitale Ausgangssignal mittelbar von der von der Ladungsquelle 2 erzeugten Ladung ab.

Das von dem als konventionelles elektrisches Bauteil ausgebildeten Analog-Digital-Umsetzer 4 erzeugte digitale Ausgangssignal wird an einen mit dem Analog-Digital-Umsetzer 4 verbundenen Prozessor 5 und an einen Summierer 6 ausgegeben.

Der Prozessor 5 und der Summierer 6 bilden dabei zusammen eine Korrekturschaltung.

Der Prozessor 5 mittelt das von dem Analog-Digital-Umsetzer 4 empfangene digitale Ausgangssignal über eine einstellbare Zeitspanne. Diese einstellbare Zeitspanne hängt insbesondere von der Art / Frequenz einer mittels der als Aufnehmer ausgebildeten Ladungsquelle 2 zu messenden Größe und der Art der Ladungsquelle 2 ab.

Das im vorliegenden Beispiel als Ladungsquelle 2 verwendete Piezo-Element gibt eine Ladung von exakt Null aus, wenn sich die auf das Piezo-Element einwirkende Kraft nicht ändert. In der Folge besitzt das von dem Piezo-Element ausgegebene Signal im Ruhezustand keinen Gleichanteil.

Weiter soll die als Aufnehmer ausgebildete Ladungsquelle 2 im vorliegenden Ausführungsbeispiel übliche mechanische Vorgänge messen. In Folge derartiger mechanischer Vorgänge gibt die als Aufnehmer ausgebildete Ladungsquelle 2 ein stochastisches Signal in Form einer Ladungserzeugung aus.

Wie vorstehend ausgeführt wird die von der Ladungsquelle 2 erzeugte Ladung durch entsprechenden Abgriff in einen Stromfluss umgewandelt, der leicht gemessen werden kann. Dieser Stromfluss entspricht der Ableitung der von der Ladungsquelle 2 erzeugten Ladung nach der Zeit $I = \dfrac{dQ}{dt}$.

Somit entspricht der Stromfluss nicht dem von der Ladungsquelle 2 ausgegebenen stochastischen Signal selber, sondern der 1. Ableitung des von der Ladungsquelle 2 ausgegebenen stochastischen Signals nach der Zeit. (Zur Ermittlung des von der Ladungsquelle 2 ausgegebenen stochastischen Signals anhand des Stromflusses ist folglich zunächst eine Integration des Stromflusses über die Zeit erforderlich.)

Die 1. Ableitung eines stochastischen Signals besitzt gemäß der Signaltheorie keinen Gleichanteil.

Ergibt die Mittelung des von dem Analog-Digital-Umsetzer 4 empfangenen digitalen Ausgangssignals über die einstellbare Zeitspanne durch den Prozessor 5, dass das empfangene digitale Ausgangssignal dennoch einen Gleichanteil aufweist, so kann dieser Gleichanteil nicht auf das von der Ladungsquelle 2 ausgegebene stochastische Signal zurückzuführen sein.

Da sowohl der verwendete Strom-Spannungs-Umsetzer 3 als auch der verwendete Analog-Digital-Umsetzer 4 selbstabgleichende Bauelemente sind, kann ein dennoch in dem digitalen Ausgangssignal des Analog-Digital-Umsetzers 4 detektierter Gleichanteil nur auf Restfehler unterhalb der Digitalisierungsstufe des Analog-Digital-Umsetzers zurückzuführen sein.

Da die Restfehler unterhalb der Digitalisierungsstufe eine statistische Größe sind, bilden sie über lange Laufzeiten des Analog-Digital-Umsetzer 4 einen Gleichanteil in dem von dem Analog-Digital-Umsetzer 4 ausgegebenen digitalen Ausgangssignal. Dieser Gleichanteil verfälscht das von der Ladungsquelle 2 ausgegebene Signal.

Da der auf Restfehler unterhalb der Digitalisierungsstufe zurückzuführende Gleichanteil in der Regel um mehrere Faktoren kleiner als ein von der Ladungsquelle 2 ausgegebenes Signal ist, kann der Prozessor 5 diesen Gleichanteil sicher von einem von der Ladungsquelle 2 ausgegebenen Signal unterscheiden.

In Abhängigkeit von dem Gleichanteil, der von dem Prozessor 5 in dem digitalen Ausgangssignal detektiert wird, gibt der Prozessor 5 einen entsprechenden Korrekturwert an den Summierer 6 aus.

Der Summierer 6 subtrahiert den von dem Prozessor 5 ermittelten Gleichanteil von dem digitalen Ausgangssignal des Analog-Digital-Umsetzers 4.

Somit erlaubt die aus dem Prozessor 5 und dem Summierer 6 gebildete Korrekturschaltung das Detektieren und die Korrektur eines in dem von dem Analog-Digital-Umsetzer 4 ausgegebenen digitalen Ausgangssignal enthaltenen Gleichanteils.

Das von der Korrekturschaltung 5, 6 korrigierte digitale Ausgangssignal wird von dem Summierer 6 an einen digitalen Integrierer 7 ausgegeben.

Bei dem digitalen Integrierer 7 handelt es sich um ein konventionelles elektronisches Bauteil, welches das empfangene digitale Ausgangssignal zum Ausgeben eines digitalen integralen Wertes integriert. Da es sich bei dem Eingangssignal des digitalen Integrierer 7 um einen digitalen Wert handelt, arbeitet der (üblicherweise in Form eines Schieberegisters ausgebildete) digitale Integrierer mathematisch hoch genau.

Am Ausgang des digitalen Integrierers 7 wird ein digitaler integraler Wert ausgegeben, welcher mit hoher Genauigkeit dem Integral über die von der Ladungsquelle 2 erzeugten Ladung entspricht.

Bei der vorstehend beschriebenen erfindungsgemäßen Schaltung zur Integration einer Ladung ist es vorteilhaft, dass die Schaltung einen einfachen, robusten und preisgünstigen Aufbau aufweist. Die für die Schaltung verwendeten Komponenten weisen eine hohe Genauigkeit auf.

Insbesondere verfügt die erfindungsgemäße Schaltung aufgrund der aus dem Prozessor und dem Summierer gebildeten Korrekturschaltung über eine hohe zeitliche Stabilität und kann somit für lange Messperioden verwendet werden.

Aufgrund der hohen Präzision auch über lange Messperioden in Verbindung mit der Einfachheit und Robustheit des Aufbaus ist die erfindungsgemäße Schaltung besonders gut für den Einsatz in autonomen Systemen, wie sie beispielsweise im Kraftfahrzeugbau und dort unter anderem in Messrädern Verwendung finden, geeignet.

Selbstverständlich kann die erfindungsgemäße Schaltung jedoch auch in allen anderen Bereichen der Technik eingesetzt werden.

In Figur 2 ist ein Blockdiagramm einer alternativen Ausführungsform der erfindungsgemäßen Schaltung zur Integration einer Ladung gezeigt.

Die in Figur 2 gezeigte Schaltung besteht lediglich aus einer Ladungsquelle 2, die über einen Eingang 8 mit der erfindungsgemäßen Schaltung 1' zur Integration einer Ladung verbunden ist.

Die erfindungsgemäße Schaltung 1' weist in dieser alternativen Ausführungsform lediglich einen Analog-Digital-Umsetzer 4 und einen digitalen Integrierer 7 auf.

Die Ladungsquelle 2 dient zum Erzeugen einer Ladung.

Der Analog-Digital-Umsetzer 4 erzeugt ein der von der Ladungsquelle 2 erzeugten Ladung entsprechendes digitales Ausgangssignal und gibt dieses an den digitalen Integrierer 7 aus.

Der digitale Integrierer 7 integriert das digitale Ausgangssignal und gibt über einen Ausgang 9 der erfindungsgemäßen Schaltung 1' einen digitalen integralen Wert aus, der dem Integral über die von der Ladungsquelle 2 erzeugten Ladung entspricht.

Da die in Figur 2 gezeigte Ausführungsform der erfindungsgemäßen Schaltung 1' zur Integration einer Ladung mit lediglich zwei elektronischen Bauelementen / Baugruppen auskommt, weist sie einen für die erzielte Langzeit-Stabilität und Genauigkeit besonders einfachen und kostengünstigen Aufbau auf.

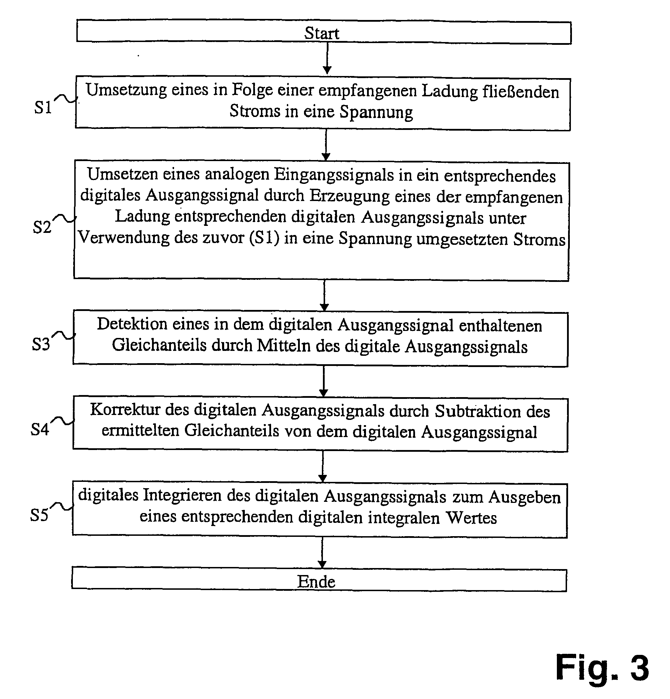

Im folgenden wird unter Bezugnahme auf das in Figur 3 gezeigte Flussdiagramm eine besonders bevorzugte Ausführungsform des erfindungsgemäßen Verfahrens zur Integration einer Ladung näher beschrieben.

Zunächst wird in einem ersten Schritt S1 ein in Folge einer empfangenen Ladung fließender Strom in eine Spannung umgesetzt.

Im folgenden Schritt S2 wird unter Verwendung des zuvor in eine Spannung umgesetzten Stroms durch Umsetzen der empfangenen analogen Spannung ein der empfangenen Ladung entsprechendes digitales Ausgangssignal erzeugt.

Anschließend wird in Schritt S3 das digitale Ausgangssignal zum Detektieren eines in dem digitalen Ausgangssignal enthaltenen Gleichanteils gemittelt.

Danach erfolgt in Schritt S4 durch Subtraktion des durch die Mittelung ermittelten Gleichenteils von dem digitalen Ausgangssignal eine Korrektur des digitalen Ausgangssignals.

Anschließend wird in Schritt S5 das digitale Ausgangssignal zum Ausgeben eines entsprechenden digitalen integralen Wertes digital integriert, bevor das Verfahren terminiert.

Selbstverständlich ist es auch möglich, das Verfahren in Form einer Endlosschleife auszugestalten, bei der das Verfahren nach Schritt S5 zu Schritt S zurückkehrt.

Gemäß einer in den Figuren nicht gezeigten alternativen Ausführungsform des erfindungsgemäßen Verfahrens zur Integration einer Ladung sind lediglich die Schritte S2 und S5 vorgesehen.

Bei dieser nicht gezeigten Ausführungsform ist es somit ausreichend, dass zunächst durch Umsetzen eines analogen Eingangssignals in ein entsprechendes digitales Ausgangssignal ein einer empfangenen Ladung entsprechendes digitales Ausgangssignal erzeugt wird, welches anschließend zur Ausgabe eines digitalen integralen Wertes digital integriert wird.

Somit ist es zur Erreichung des mit dem erfindungsgemäßen Verfahren angestrebten Erfolges ausreichend, vor dem Integrieren der Ladung diese zu digitalisieren und die Integration erst anschließend digital durchzuführen.

**Patentansprüche**

1. Schaltung zur Integration einer Ladung, aufweisend einen Eingang (8) zum Empfangen einer Ladung, einen Integrierer (7) zum Integrieren eines Eingangssignals und zum Ausgeben eines integralen Wertes sowie einen Analog-Digital-Umsetzer (4) zum Umsetzen eines analogen Eingangssignals in ein entsprechendes digitales Ausgangssignal, **dadurch gekennzeichnet, dass** der Analog-Digital-Umsetzer (4) ein der von dem Eingang (8) empfangenen Ladung entsprechendes digitales Ausgangssignal erzeugt und der Integrierer (7) als digitaler Integrierer ausgebildet ist und das von dem Analog-Digital-Umsetzer (4) empfangene digitale Ausgangssignal zum Ausgeben eines integralen Wertes integriert.

2. Schaltung (1) nach Anspruch 1, **dadurch gekennzeichnet, dass** die Schaltung (1) ferner einen Strom-Spannungs-Umsetzer (3) zur Erzeugung einer von einem Eingangsstrom abhängenden Ausgangsspannung aufweist, wobei der Strom-Spannungs-Umsetzer (3) ausgebildet ist, einen in Folge einer von dem Eingang (8) empfangenen Ladung fließenden Strom in eine Spannung umzusetzen und diese Spannung an den Analog-Digital-Umsetzer (4) auszugeben, und der Analog-Digital-Umsetzer (4) ein der von dem Strom-Spannungs-Umsetzer (3) empfangenen Spannung entsprechendes digitales Ausgangssignal erzeugt und an den digitalen Integrierer (7) ausgibt.

3. Schaltung (1) nach Anspruch 1 oder 2,

**dadurch gekennzeichnet,**
**dass** die Schaltung (1) ferner eine Korrekturschaltung (5, 6) aufweist, die zwischen dem Analog-Digital-Umsetzer (4) und dem digitalen Integrierer (7) angeordnet ist,
wobei die Korrekturschaltung (5, 6) ausgebildet ist, um einen in dem von dem Analog-Digital-Umsetzer (4) empfangenen digitalen Ausgangssignal enthaltenen Gleichanteil zu detektieren und vor der Ausgabe an den digitalen Integrierer (7) zu korrigieren.

4. Schaltung (1) nach Anspruch 3,
 **dadurch gekennzeichnet, dass**
die Korrekturschaltung (5, 6) das von dem Analog-Digital-Umsetzer (4) empfangene digitale Ausgangssignal über einen einstellbaren Zeitraum mittelt, um einen in dem digitalen Ausgangssignal enthaltenen Gleichanteil zu detektieren.

5. Schaltung (1) nach Anspruch 3 oder 4,
**dadurch gekennzeichnet, dass**
die Korrekturschaltung (5, 6) einen ermittelten Gleichanteil in dem von dem Analog-Digital-Umsetzer (4) empfangenen digitalen Ausgangssignal vor der Ausgabe an den digitalen Integrierer (7) subtrahiert.

6. Schaltung (1) nach einem der vorangegangenen Ansprüche,
**dadurch gekennzeichnet, dass**
der Eingang (8) mit einer Ladungsquelle (2) in Form eines Piezo-Elements verbunden ist.

7. Verfahren zur Integration einer Ladung, aufweisend die folgenden Schritte:

- (S5) Integrieren eines Eingangssignals und Ausgeben eines integralen Wertes; sowie
- (S2) Umsetzen eines analogen Eingangssignals in ein entsprechendes digitales Ausgangssignal,

**dadurch gekennzeichnet, dass**
in dem Schritt (S2) des Umsetzen eines analogen Eingangssignals in ein entsprechendes digitales Ausgangssignal ein einer empfangenen Ladung entsprechendes digitales Ausgangssignal erzeugt wird, und
der Schritt (S5) des Integrieren erst nach dem Schritt (S2) des Umsetzen eines analogen Eingangssignals in ein entsprechendes digitales Ausgangssignal unter Verwendung des digitalen Ausgangssignals digital erfolgt.

8. Verfahren nach Anspruch 7,
**dadurch gekennzeichnet, dass** das Verfahren ferner folgenden Schritt aufweist:

- (S1) Umsetzen eines in Folge einer empfangenen Ladung fließenden Stroms in eine Spannung;

wobei der Schritt (S2) des Umsetzen eines analogen Eingangssignals in ein entsprechendes digitales Ausgangssignal unter Verwendung des zuvor in eine Spannung umgesetzten Stroms erfolgt.

9. Verfahren nach Anspruch 7 oder 8,
**dadurch gekennzeichnet, dass** das Verfahren ferner folgende Schritte aufweist:

- (S3) Detektieren eines in dem digitalen Ausgangssignal enthaltenen Gleichanteils; und
- (S4) Korrektur des digitalen Ausgangssignals vor dem Schritt (S5) des Integrieren.

10. Verfahren nach Anspruch 9,
**dadurch gekennzeichnet, dass**
der Schritt (S3) des Detektieren eines in dem digitalen Ausgangssignal enthaltenen Gleichanteils durch Mitteln des digitale Ausgangssignals über einen einstellbaren Zeitraum erfolgt.

11. Verfahren nach Anspruch 3 oder 4,
**dadurch gekennzeichnet, dass**
der Schritt (S4) der Korrektur des digitalen Ausgangssignals durch Subtraktion des ermittelten Gleichanteils von dem digitalen Ausgangssignal erfolgt.

**Fig. 1**

**Fig. 2**

**Fig. 4**
**Stand der Technik**

```
┌─────────────────────────────────────────────────────────────┐
│                          Start                                │
└─────────────────────────────────────────────────────────────┘
                              │
                              ▼
      ┌─────────────────────────────────────────────────────────┐
  S1  │ Umsetzung eines in Folge einer empfangenen Ladung         │
      │ fließenden Stroms in eine Spannung                        │
      └─────────────────────────────────────────────────────────┘
                              │
                              ▼
      ┌─────────────────────────────────────────────────────────┐
      │ Umsetzen eines analogen Eingangssignals in ein            │
      │ entsprechendes digitales Ausgangssignal durch Erzeugung   │
  S2  │ eines der empfangenen Ladung entsprechenden digitalen     │
      │ Ausgangssignals unter Verwendung des zuvor (S1) in eine   │
      │ Spannung umgesetzten Stroms                               │
      └─────────────────────────────────────────────────────────┘
                              │
                              ▼
      ┌─────────────────────────────────────────────────────────┐
  S3  │ Detektion eines in dem digitalen Ausgangssignal           │
      │ enthaltenen Gleichanteils durch Mitteln des digitale      │
      │ Ausgangssignals                                           │
      └─────────────────────────────────────────────────────────┘
                              │
                              ▼
      ┌─────────────────────────────────────────────────────────┐
  S4  │ Korrektur des digitalen Ausgangssignals durch Subtraktion │
      │ des ermittelten Gleichanteils von dem digitalen           │
      │ Ausgangssignal                                            │
      └─────────────────────────────────────────────────────────┘
                              │
                              ▼
      ┌─────────────────────────────────────────────────────────┐
  S5  │ digitales Integrieren des digitalen Ausgangssignals zum   │
      │ Ausgeben eines entsprechenden digitalen integralen Wertes │
      └─────────────────────────────────────────────────────────┘
                              │
                              ▼
┌─────────────────────────────────────────────────────────────┐
│                          Ende                                 │
└─────────────────────────────────────────────────────────────┘
```

**Fig. 3**